# EUROPÄISCHE PATENTSCHRIFT

(11) **EP 2 789 006 B1**
(45) Veröffentlichungstag und Bekanntmachung des Hinweises auf die Patenterteilung: **31.10.2018**
(21) Anmeldenummer: 12810067.4
(22) Anmeldetag: 23.11.2012
(51) Int. Cl.: H01J 37/34, C23C 14/00, C23C 14/34

(54) **REAKTIVER SPUTTERPROZESS**
REACTIVE SPUTTERING PROCESS
PROCÉDÉ DE PULVÉRISATION RÉACTIVE

(30) Priorität: 05.12.2011 US 201161566836 P
(43) Veröffentlichungstag der Anmeldung: 15.10.2014
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT)
(74) Vertreter: Kempkens, Anke
(86) Internationale Anmeldenummer: PCT/EP2012/004848
(87) Internationale Veröffentlichungsnummer: WO 2013/083238

(56) Entgegenhaltungen:
- EP-A1- 1 553 206
- WO-A1-2007/147582
- WO-A1-2009/071667
- DE-A1-102006 017 382
- DE-U1-202010 001 497

## Beschreibung

Die vorlegende Erfindung bezieht sich auf ein Verfahren zum reaktiven Sputtern. Beim Sputtern, welches auch als Kathodenzerstäuben bekannt ist, wird mittels lonenbeschuss Material aus der Oberfläche eines Festkörpers (Target), der die Kathode bildet, herausgeschlagen und geht in die Gasphase über. Die Kathode wird auf negatives Potential gelegt, um bereitgestellte Ionen auf diese hin zu beschleunigen. Sputtern wird häufig zur Beschichtung von Substraten eingesetzt. Die Substrate werden in die Nähe des Targets gebracht oder an diesem vorbeigeführt. Das aus der Kathode herausgeschlagene (=zerstäubte) gasförmige Material setzt sich dann auf den Substraten ab. Es handelt sich dabei also um eine Abscheidung aus der Gasphase und gehört zu den unter dem Namen PVD (=physical vapor deposition) bekannten Beschichtungsverfahren. Damit das zerstäubte Material weitgehend ungestört, d.h. ohne Stösse mit anderen Teilchen zu den Substraten gelangt darf nur ein geringer Umgebungsgasdruck vorhanden sein. Die mittlere freie Weglänge sollte mindestens so gross wie der Abstand von der Kathode zu den Substraten sein. Sputterbeschichtet wird daher in einer evakuierbaren Prozesskammer. Typische Verfahrensdrücke liegen bei 5*10⁻³mbar oder darunter.

Um die für den Beschuss der Kathode notwendigen Ionen zu erzeugen, wird in die Prozesskammer ein inertes Arbeitsgas eingelassen. Sehr häufig kommt Argon als Arbeitsgas zum Einsatz. Durch Stossionisation werden die Atome des Arbeitsgases ionisiert. Bei der Stossionisation stossen im Wesentlichen freie Elektronen mit den Atomen zusammen und ionisieren diese. Auf diese Weise entsteht ein Plasma aus dem heraus die Ionen von der Kathode angezogen werden. Eine hohe Elektronendichte ist dem Prozess daher zuträglich. Beim sogenannten Margnetronsputtern wird hinter der Kathode ein Magnetsystem angeordnet dessen Magnetfeld in den Bereich über der Tragetoberfläche hinausragt. Dieser hinausragende Teil des Magnetfeldes, welcher häufig als Tunnel realisiert ist und bei Rechteckkathoden oft an die Form einer Rennbahn (racetrack) erinnert, zwingt die Elektronen auf eine Spiralbahn. Durch die dadurch erzwungene Wegverlängerung erhöht sich die Zahl der Stösse pro Elektron und die Ionisation der Arbeitsgasatome wird effizienter.

Aufgrund der an der Kathode angelegten negativen Spannung werden die Arbeitsgasionen auf diese hin zu beschleunigt. Während des Sputterns kommt es daher zu einem Stromfluss welcher durch einen leistungsfähigen Generator aufrecht erhalten werden muss. Beim klassischen Sputterverfahren ist der Ionisierungsgrad des aus dem Target herausgeschlagenen Materials sehr klein. Wird jedoch mit Stromdichten gearbeitet, welche grösser als 0.5A/cm² sind, so erhöht sich der lonisierungsgrad drastisch. Diese Ionisation des zerstäubten Materials kann beim Schichtaufbau vorteilhaft genutzt werden. Es kommt aber durch die hohe Stromdichte am Target zur einem erheblichen Energieeintrag in das Target und führt damit zu dessen Aufheizung. Aus diesem Grund wird bei solchen Stromdichten nur mit Pulsen gearbeitet, um dem Target Zeit zum Abkühlen zu geben. Ein solches Verfahren wird Hochleistungsimpulsmagnetronsputtern (high-power impulse magnetron sputtering, HiPIMS) genannt.

Aufgrund des im Verfahren notwendigerweise durch die Targetoberfläche fliessenden elektrischen Stromes ist das Sputterverfahren auf elektrisch leitende Materialien begrenzt. Allerdings kann während des Sputterns ein Reaktivgas in die Prozesskammer eingelassen werden, welches dann mit dem zerstäubten Material eine Verbindung eingeht. Allerdings kommt es ab einem bestimmten Reaktivgasfluss zu einem drastischen Ratenabfall. Dies ist ein Kennzeichen dafür, dass die Targetoberfläche als Resultat der Reaktion des Rekativgases mit dem Targetmaterial mit einer nicht oder schlecht leitenden Schicht überzogen ist. Man spricht in diesem Fall von einem vergifteten Target. Der sogenannte metallische Zustand lässt sich dann nur noch mittels drastischer Rücknahme der Reaktivgaszufuhr wieder herstellten.

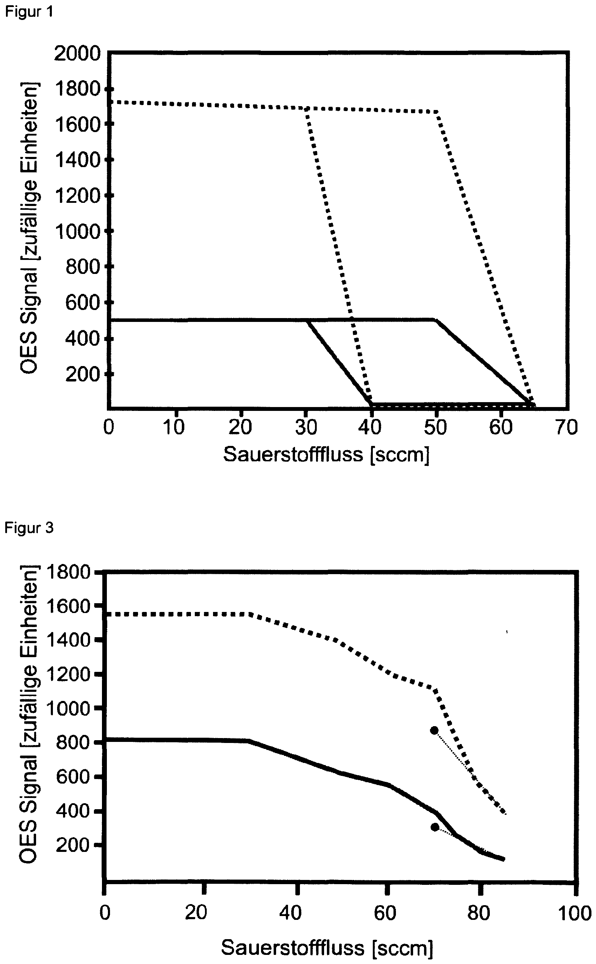

Die Figur 1 zeigt eine typische Hysterese am Beispiel der optischen Signale für Al und Chrom für kurze Pulsdauer (70µs) einer HiPIMS Entladung. Die Pulsleistung betrug dabei 500W/cm2 und die zeitlich gemittelte Leistung 2.5kW. Die durchgezogenen Linien geben die optischen Signale für Chrom (520nm) wieder, die gepunkteten Linien geben die optischen Signale für Aluminium (396nm) wieder. Die oberen Linien sind mit steigendem Sauerstofffluss verbunden, die unteren Linien sind mit sinkendem Sauerstofffluss verbunden. Deutlich ist der Ratenabfall ab einem kritischen Sauerstofffluss zu sehen. Die Rate im vergifteten Modus fällt dabei auf sehr kleine Werte, d.h. wird ca. Faktor 100 kleiner als die Rate im metallischen Modus. Im vergifteten Modus ist die Targetoberfläche oxidiert. Lediglich durch eine drastische Rücknahme des Sauerstoffflusses Iann die Targetoberfläche wieder in den metallischen Zustand zurückgeführt werden.

Es gibt verschiedene Versuche, eine solche Hysterese zu vermeiden. In der WO 03/006703 schlagen Nyberg et al eine Methode zum reaktiven Sputtern vor, welche durch eine räumliche Begrenzung des Plasma Racetracks eine hohe Stromdichte auf dem Sputtertarget erzeugen. Dadurch wird das Plasma auf einen kleinen Bereich der Targetoberfläche begrenzt. Nyberg et al beschreiben, dass es wichtig ist, diesen Bereich zu bewegen und zwar einerseits langsam genug um zu garantieren, dass meist im metallischen Mode zerstäubt wird, allerdings schnell genug um ein Aufschmelzen der Targetoberfläche zu vermeiden.

Demgegenüber beschreiben Wallin et al in der WO 2009/010330 ein HiPIMS Verfahren demgemäss mit Pulsen gearbeitet wird, welche eine Pulslänge zwischen 2µs und 200µs haben. Dabei wird mit Spannungen gearbeitet welche zwischen 200V und 2000V liegen. Es wird mit Leistungsdichten gearbeitet, die über 200Wcm⁻² liegen. Die entsprechenden Leistungspulse werden durch eine Generator bereitgestellt der eine Pulseinheit umfasst. Dadurch wird während jedem Puls eine Magnetron-Sputter Glimmentladung mit zu einem Maximum ansteigendem Strom ausgelöst, bei welchem das Maximum des Leistungspulses erreicht wird. Zwischen zwei aufeinanderfolgenden Pulsen kommt es nicht zur elektrischen Leistungseinspeisung in das Beschichtungssystem. Es kommen Sauerstoffflüsse zum Einsatz, die zwischen 200sccm und 2000sccm liegen. Wie Wallin et al beschreiben, werden hierdurch am zu beschichtenden Substrat reaktive Bedingungen erziehlt wobei gleichzeitig das Target im Wesentlichen im metallischen Zustand ist, d.h. die Targetoberfläche nicht signifikant mit Reaktivgas Weiter sind in WO 2009/071667 A1 und WO 2007/147582 A1 reaktive Hochleistungs-Puls-Magnetronsputterverfahren beschrieben, bei denen der Sputterprozess im Übergangsbereich zwischen vergifteten und metallischem Mode durchgeführt wird. Hier ist die Regelung der Spannung, des Reaktivgasflusses, die Dauer des elektrischen Pulses und die Frequenz der elektrischen Pulse so gewählt, dass sich das Target in einem Zustand zwischen dem metallischen und dem vergifteten Zustand befindet, da die Aufdampfrate und die Schichteigenschaften in diesem Bereich optimal sind. Das heißt, die Parameter sind so gewählt, dass das Sputtern im Übergangsbereich ausgeführt wird und nicht während dem Sputtern aus einem ersten Zustand in einen zweiten Zustand übergeht.

Sowohl Nyberg et al als auch Wallin et al wählen also die Prozessparameter so, dass im metallischen Mode vom Target gesputtert wird. Die vorliegende Erfindung geht einen anderen Weg. Sie beschreibt eine Methode zum Betreiben einenr Sputterentladung in Kombination mit hohen Stromdichten (HiPIMS) welche grösser als 0.5A/cm² sind. Ausgehend von einem Target, das zu Beginn des Leistungspulses in einem ersten Zwischenzustand zwischen vergiftetem und metallischen Zustand ist wird im erfindungsgemässen Prozess die Stromdichte bzw. die so erhaltene Sputterleistungsdichte in Kombination mit der Pulslänge so gewählt, dass der reaktive Sputterprozess am Ende des Leistungspulses sich in einem zweiten Zwischenzustand zwischen vergiftetem und metallischem Zustand befindet wobei der zweite Zwischenzustand deutlich metallischeren Charakter aufweist als der erste Zwischenzustand. Dabei kann der erste Zwischenzustand auch der absolut vergiftete Zustand sein und der zweite Zwischenzustand kann auch der metallische Zustand sein. Vorzugsweise entspricht der erste Zwischenzustand aber deutlich nicht dem absolut vergifteten Zustand und/oder entspricht der zweite Zwischenzustand deutlich nicht dem im Wesentlichen metallischen Zustand. Wesentlich dabei ist, dass im Unterschied zum Stand der Technik nicht meist von einem Target im metallischen Zustand zerstäubt wird sondern erfindungsgemäss durch Anlegen eines definierten Energiepulses der Zustand von einem mehr oder weniger vergifteten Target zu einem metallischeren Target während des Pulses durchfahren wird. Hierbei ist einerseits die beim HiPIMS Prozess vorliegende hohe Stromdichte am Target unterstützend und andererseits muss ein Puls genügend lange andauern, um das Target effektiv zumindest teilweise zu entgiften. Die Pulspause wird dann so lange oder kurz gewählt, dass die Vergiftung des Targets dem ersten Zwischenzustand entspricht. Mit dem darauffolgenden Puls wird das Target dann wiederum bis hin zum zweiten Zwischenzustand entgiftet. Eine erfindungsgemässe Pulsdauer liegt zwischen 50µs und 100ms. Der eigentliche den Prozess stabilisierende Effekt tritt aber oberhalb ca 500µs auf. Die bevorzugte Erfindungsgemässe Pulsdauer liegt daher zwischen 500µs und 100ms, wobei besonders bevorzugt eine Pulsdauer zwischen 1ms und 10ms liegt und eine Pulsdauer zwischen 1ms und 5ms weitere Vorzüge hat.

Wie oben beschrieben wird erfindungsgemäss ein definierter Energiepuls angelegt. Dies kann beispielsweise dadurch erreicht werden, dass im Gegensatz zum oben erwähnten Stand der Technik zwischen zwei aufeinanderfolgenden Pulsen an einem Target die Leistungseinspeisung in das Beschichtungssystem nicht unterbrochen wird sondern mehrere Targets nacheinander mit Leistung beaufschlagt werden so dass die Leistungsabgabe in das Beschichtungssystem über mehrere Pulsfolgen hinweg im Wesentlichen ununterbrochen und konstant vollzogen wird. Da es während dieser Pulsfolgen nicht zur Unterbrechung der Leistungsabgabe kommt sind auch keine weiteren Leistungsaufbauintervalle notwendig. Es kann ein einfacher DC-Generator zum Einsatz kommen welcher über mehrere Pulse hinweg konstant seine Leistung an das Beschichtungssystem abgiebt. Als Resultat können an den einzelnen Targets sehr gut definierte und reproduzierbare Leistungspulse verwirklicht werden. Eine solche Methode der Bereitstellung von sequenziellen Leistungspulsen wird beispielsweise in der WO2012/143091 vom selben Anmelder beschrieben.

Als Resultat der erfindungsgemässen Methode erhält man einen sehr stabilen Prozess ohne Hysterese der Sputterentladung bzgl. Des reaktiven Gasdruckes und eine hohe Beschichtungsrate. Dies gilt speziell bei Oxid-Sputterprozessen wie z.B. der Herstellung von Aluminiumoxid. Ein weiterer Vorteil der Methode liegt in der hohen Stromdichte der erfindungsgemässen Sputterentladung welche die Ionisation der gesputterten Teilchen erhöht.

Die Erfindung wird nun im Detail und anhand der Figuren beispielhaft näher erläutert.
Figur 1 zeigt eine typische Hysterese gemäss Stand der Technik
Figur 2 ist ein screenshot der einen erfinderischen Leistungspuls an einer Sputterkathode zeigt.
Figur 3 zeigt den Ratenabfall bei einem Reaktivprozess mit Sauerstoff als Reaktivgas bei Verwendung mit langen HiPIMS Pulsen.
Figur 4 zeigt für einen 5 stündigen Beschichtungsprozess de Verlauf des optischen Signals.
Figur 5a bis d zeigt den Verlauf der Spannungs- und Strompulse bei unterschiedlichen Arbeitspunkten.

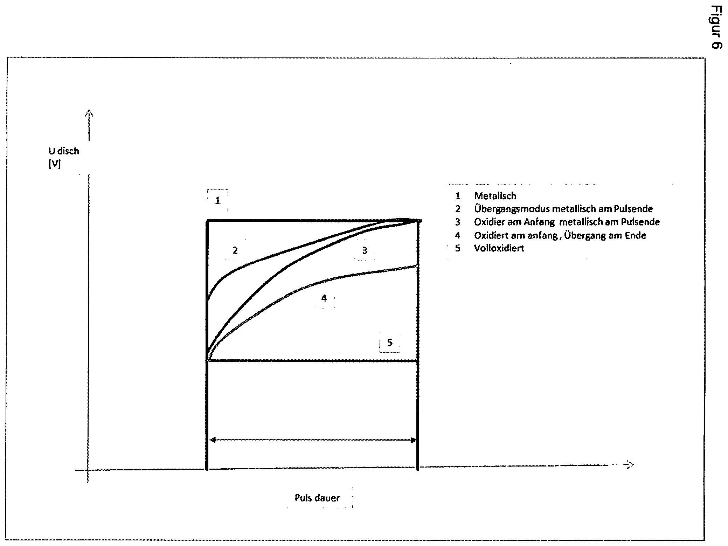

Figur 6 ist eine Darstellung der Möglichkeit den reaktiven Sputterprozess anhand von Spannungswerten zu regeln.

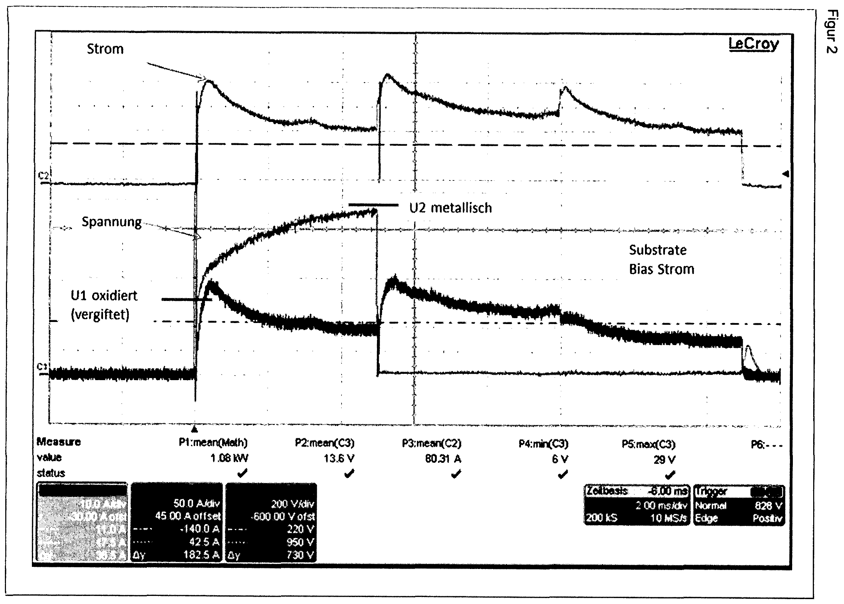

In Figur 2 dargestellt ist ein erfinderischer Leistungspuls an einer Sputterkathode. In diesem Beispiel wurde als Targetmaterial ein AlCr (70:30) Target eingesetzt und ein Sauerstofffluss von 40sccm aufrecht erhalten. Die Figur zeigt Die Entladespannung reagiert sehr sensitiv auf die Vergiftung der Targetoberfläche im Sputterracetrack:
- Zu Beginn des Leistungspulses ist der Spannungslevel U1 = 400V. Dies ist einem vergifteten (im Beispiel oxidierten) Target zuzuordnen.
- Am Ende des Leistungspulses welcher konstant 500W/cm² beträgt ist der Spannungslevel U2 = 680V einem teilweise oxidiertem Zustand der Targetoberfläche zuzuordnen.

Daraus kann die Schlussfolgerung gezogen werden, dass der dem plasma-Racetrack entsprechende Targetoberflächenanteil während der Pulsdauer von anfänglich oxidiert auf einen Zwischenzustand zu teiloxidiert bzw. metallisch übergeht.

Werden lange HiPIMS Pulse verwendet, wie zum Beispiel 5ms bei einer Pulspower von wiederum 500W so zeigt sich bei zunehmendem Reaktivgasfluss (beispielsweise Sauerstoff) ein kontinuierlicher Ratenabfall (siehe Figur 3). Erstaunlicher Weise ist der Ratenabfall monoton und es kommt nicht zu einem Hystereseverhalten. Dies eröffnet die Möglichkeit mit dem erfindungsgemässen Verfahren den Arbeitspunkt beliebig bei einem Zustand des Target einzustellen.

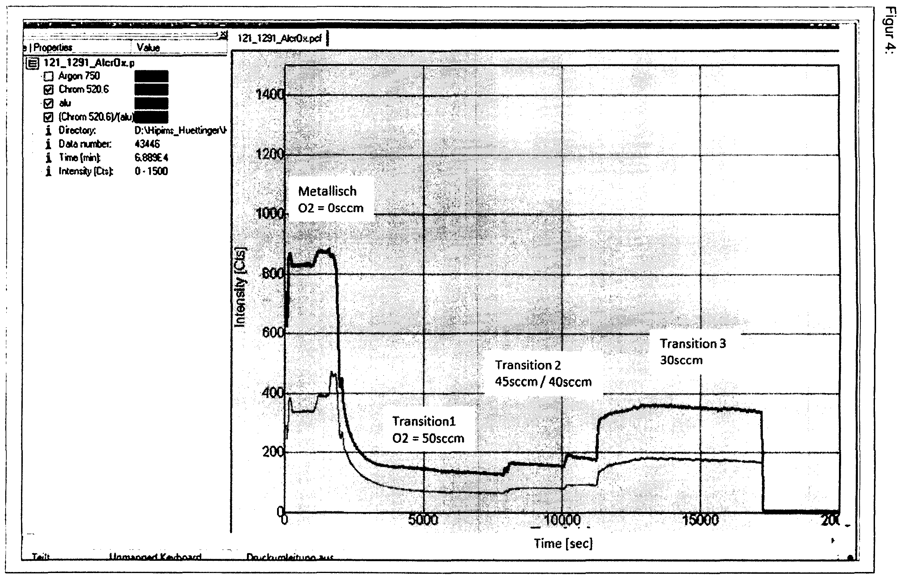

Das erfindungsgemässe Verfahren erweist sich als ausserordentlich stabil. Um dies zu demonstrieren wurdeder Beschichtungsprozess mit den oben genannten Parametern über 5 Stunden aufrecht erhalten, wobei während dieser Zeit unterschiedliche Sauerstoffflüsse und damit Arbeitspunkte gewählt wurden. Es wurde mit einer metallischen Schicht begonnen, gefolgt von unterschiedlichen Abschnitten mit unterschiedlichen Sauerstoffflüssen. Figur 4 zeigt den Verlauf des optischen Signals der HiPIMS Plasmaemision anhand der Emissionslinien von Aluminium und Chrom in Abhängigkeit der Zeit. Deutlich sichtbar ist, dass der Beschichtungsprozess über die gesamte Zeit sehr stabil verläuft.

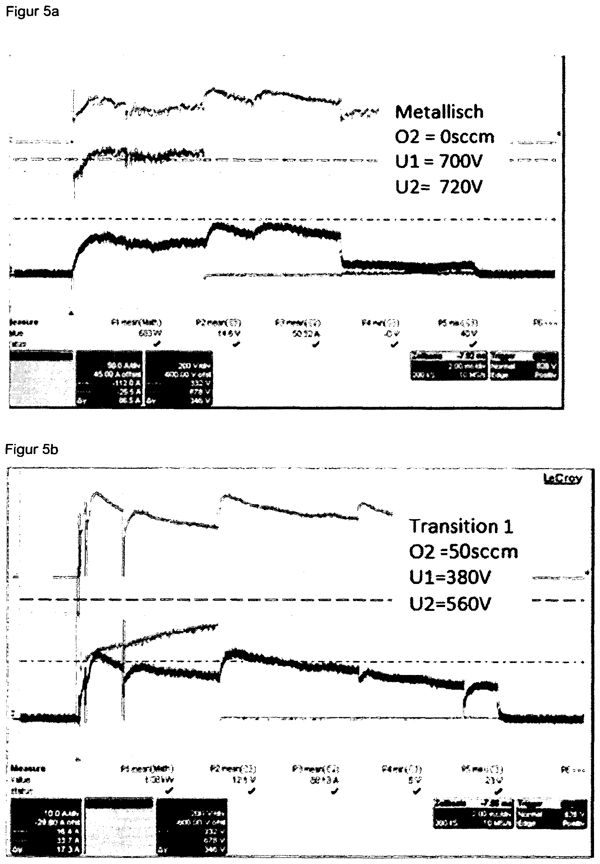

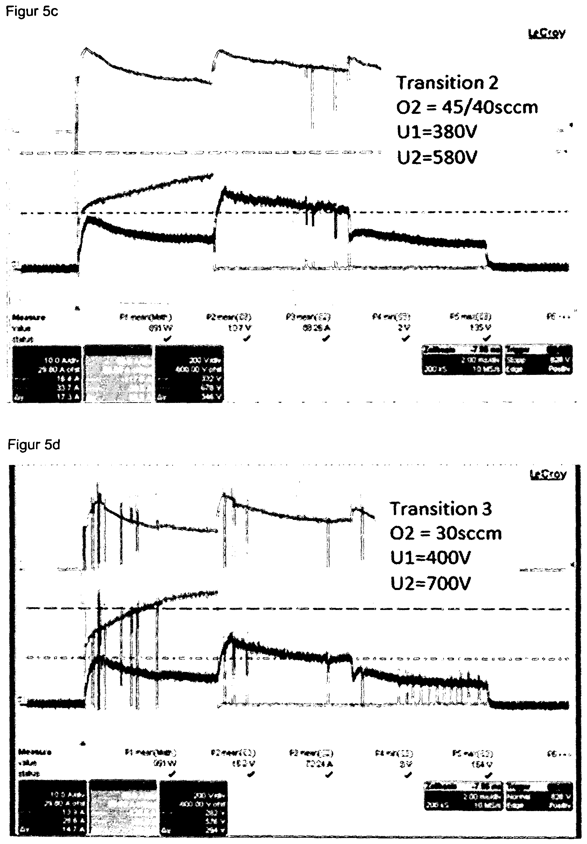

Zur Ergänzung zeigt die Figur 5 den Verlauf der Spannungs- und Strompulse bei den unterschiedlichen Arbeitspunkten des in Figur 4 gezeigten Diagramms. In Figur 5a sind die Verläufe gezeigt wenn kein Reaktivgas in die Kammer eingelassen wird. Der rein metallische Mode ist realisiert. Die Spannung bleibt relativ konstant. Gleiches gilt für den Strom. In Figur 5b herrscht ein Reaktivgasfluss von 50sccm. Die Entladespannung startet bei 380V und endet bei 560V. Somit wird der metallische Zustand der Targetoberfläche gar nicht erreicht. In Figur 5c herrscht eine Reaktivgasfluss von zunächst 45 sccm und dann 40 sccm. Die Entladespannung am Ende des Pulses hat sich nun auf 580V erhöht, den Wert der durch eine metallische Oberfläche gegeben ist aber noch nicht erreicht. In Figur 5d schliesslich liegt ein Reaktivgasfluss von 30 sccm vor. Bei diesem Reaktivgasfluss ist die Entladespannung Anfangs bei 400V und am Ende des Pulses liegt sie bei 700V, d.h. mit Ende des Pulses wird vermutlich im Wesentlichen der metallische Zustand der Targetoberfläche erreicht. Dabei wird deutlich, dass mit zunehmender Oxidation der Targetoberfläche der Anfangswert der Entladespannung des Leistungspulses sinkt. Durch die Dauer des Hochleistungspulses wird gewährleistet, dass das Target zum Ende des Leistungspulses wieder einen Zustand im Übergangsbereich zwischen oxidiert und metallisch einnimmt oder metallisch ist, denn bei totaler Oxidation der Targetoberfläche würde die Spannung konstant bei dem tiefen Anfangswert liegen. Im Gegensatz zum Stand der Technik wird aber gerade nicht so vorgegangen, dass während des Pulses meisten von einer metallischen Targetoberfläche zerstäubt wird.

Das erfindungsgemässe Verfahren eröffnet ausserdem die Möglichkeit zu einer neuen, ebenfalls erfinderischen Regelung des reaktiven Prozesses.

Gemäss dem bisher bekannten Stand der Technik wird nämlich entweder mittels der optischen Emission oder mittels einer konstant gehalltenen Sputterspannung geregelt. Mit beiden Verfahren kann man im Übergangsbereich eines reaktiven Prozesses stabil arbeiten. Speziell die Spannungsregelung ist im allgemeinen ein einfacher, stabiler uns sehr sensitiver Vorgang.

Die Entladespannung einer oxidierten Targetoberfläche von z.B. Aluminiumoxid oder AlCrOₓ ist im Bereich von 300 bis 400V. Die spannung bei Teiloxidation ist entsprechend höher und die Spannung bei Metallsputtern liegt bei ca. 600 bis 800V. Dies kann erfindugsgemäss bei einem Verfahren mit während des Leistungspulses im wesentlichen konstanter Leistungsabgabe vorteilhaft zur Regelung des Reaktivprozesses ausgenutzt werden. Erfindungsgemäss kann nämlich der Prozess mittels Anfangswert der Spannung und Endwert der Spannung eines Leistungspulses geregelt werden. D.h. es wird der reaktive Sputterprozess anhand des Spannungswertes am Anfang eines HIPIMS Leistungspulses und dem jeweiligen Spannungswert am Ende des Leistungspulses geregelt. Dies ist schematisch in Figur 5 dargestellt.

Somit kann die Pulsleistung und die Pulsdauer eines reaktiven HIPIMS-Sputterverfahren erfindungsgemäss so gewählt werden, dass am Pulsanfang ein bestimmter stärker oxidierter Targetzustand am Pulsende ein bestimmter zumindest schwächer oxidierter Targetzustand entsteht, wobei dies im Spannungsverlauf sichtbar ist.

Es sei noch darauf hingeweisen dass als Reaktivgas für das erfindungsgemässe Verfahren beispielsweise Sauerstoff, Stickstoff, C2H2, CH4 und deren Mischungen in Frage kommen.
So kann man beim erfindungsgemässen Sputtern mit Sauerstoff beispielsweise Stickstoff als zweites Reaktivgas hinzugegeben.
Beim erfindungsgemässen Sputtern mit Stickstoff kann beispielsweise C2H2 oder CH4 als zweites Reaktivgas hinzugegeben werden.

Es wurde ein Verfahren zum reaktiven Sputtern offenbart, bei dem mittels lonenbeschuss Material aus der Oberfläche eines ersten Targets herausgeschlagen wird und in die Gasphase übergeht, wobei an das Target pulsweise negative Spannung dergestalt angelegt wird dass es an der Targetoberfläche zu einem elektrischen Strom mit einer Stromdichte von grösser als 0.5A/cm² kommt so dass das in die Gasphase übergehende Material zumindest teilweise ionisiert ist und bei dem ein Reaktivgasfluss aufgebaut wird und Reaktivgas mit dem Material der Targetoberfäche reagiert. Die Dauer eines Spannungspulses wird dabei so gewählt dass während des Spannungspulses die Targetoberfläche an der oder den Stellen an denen der Strom fliesst die meiste Zeit zumindest teilweise mit einer Verbindung aus Reaktivgas und Targetmaterial bedeckt ist und somit die Targetoberfläche in einem ersten Zwischenzustand ist und diese Bedeckung am Ende des Spannungspulses geringer ist als am Anfang des Spannungspulses und somit die Targetoberfläche am Ende des Spannungspulses in einem zweiten Zwischenzustand ist.

Der durch die Spannung und die Strom erzeugte Leistungspuls kann zumindest über die meiste Zeit des Pulses vorzugsweise über im wesentlichen die gesamte Pulsdauer auf einer im Wesentlichen konstanten Leistungsamplitude gehalten werden.

Die Pulsdauer kann zwischen 500µs und 100ms, vorzugsweise zwischen 1ms und 10ms und besonders bevorzugt zwischen 1ms und 5ms liegen

Die Unterbruchszeit oder die Unterbruchszeiten zwischen einem ersten Puls und einem späteren Puls kann/können so gewählt werden, dass in dieser Zeit das Reaktivgas mit der Targetoberfläche so weit reagieren kann, dass am Anfang des dauffolgenden Pulses die Targetoberfläche bezüglich Bedeckung im Wesentlichen gleichen Zwischenzustand ist wie am Anfang des ersten Pulses. Der spätere Puls kann ein dem ersten Puls direkt folgender Puls sein, also so dass kein weiterer Puls dazwischen liegt.

Es kann zumindest ein zweites Target verwendet werden und zum pulsweisen Spannungsbeaufschlagung kann der Leistungseintrag sequenziell vom ersten Target auf das zweite Target und gegebenenfalls sequenziell auf die weiteren Targets geschalten werden, so dass während zumindest einer solchen Sequenz die Leistungsabgabe eines die Leistung bereitstellenden Generators der vorzugsweise ein DC-Generator ist, nicht unterbrochen wird.

Das reaktive Sputterverfahrens kann so geregelt werden dass dass beim Erreichen einer vorbestimmten mit einem zweiten Zwischenzustand der Targetoberfläche korrelierenden Spannung ein Spannungspuls beendet wird.

Die Regelung kann so ausgestaltet werden dass im Falle des Unterschreitens einer vorbestimmten Spannung am Pulsanfang die Unterbrechungszeit kürzer als die vorhergenden Unterbrechungszeit gewählt wird und beim Überschreiten einer vorbestimmten Spannung am Pulsanfang die Unterbrechungszeit länger als die vorhergenden Unterbrechungszeit gewählt wird.

Der zweite Zwischenzustand kann im Wesentlichen der metallische Zustand oder nicht der metallische Zustand der Targetoberfläche sein.

Das oben beschriebene Sputterverfahren wird vorzugsweise zur Beschichtung von Substraten eingesetzt. Aufgrund der hohen Ionendichte kann es allerdings auch bei anderen Verfahren, wie zum Beispiel das Sputterätzen, die Oberflächenreinigung oder die lomenimplantation eingesetzt werden.

## Patentansprüche

1. Verfahren zum reaktiven Sputtern bei dem mittels lonenbeschuss Material aus der Oberfläche eines ersten Targets herausgeschlagen wird und in die Gasphase übergeht, wobei an das Target pulsweise negative Spannung dergestalt angelegt wird dass es an der Targetoberfläche zu einem elektrischen Strom mit einer Stromdichte von grösser als 0.5A/cm² kommt so dass das in die Gasphase übergehende Material zumindest teilweise ionisiert ist und bei dem ein Reaktivgasfluss aufgebaut wird und Reaktivgas mit dem Material der Targetoberfläche reagiert, wobei während eines Spannungspulses die Targetoberfläche an der oder den Stellen an denen der Strom fliesst die meiste Zeit zumindest teilweise mit einer Verbindung aus Reaktivgas und Targetmaterial bedeckt ist und somit die zu sputternde Targetoberfläche in einem ersten Zwischenzustand ist, **dadurch gekennzeichnet, dass** der durch die Spannung und die Strom erzeugte Leistungspuls zumindest über die meiste Zeit des Pulses vorzugsweise über im Wesentlichen die gesamte Pulsdauer auf einer im Wesentlichen konstanten Leistungsamplitude gehalten wird, und Stromdichte bzw. die so erhaltende Sputterleistungsdichte und die Pulsdauer so gewählt werden, dass die abgesputterte Targetoberfläche am Ende des Leistungspulses in einem zweiten Zwischenzustand ist, bei der die Bedeckung der Verbindung aus Reaktivgas und Targetmaterial am Ende des Leistungspulses geringer ist als am Anfang des Leistungspulses und dies im Spannungsverlauf sichtbar ist.

2. Verfahren nach Anspruch 1, **dadurch gekennzeichnet, dass** zu Beginn des Leistungspulses ein erster Spannungslevels U1 und am Ende des Leistungspulses ein zweiter Spannungslevel U2 gemessen wird, wobei U2 > U1.

3. Verfahren nach einem der vorangehenden Ansprüche, **dadurch gekennzeichnet, dass** die Pulsdauer zwischen 500µs und 100ms, vorzugsweise zwischen 1ms und 10ms und besonders bevorzugt zwischen 1ms und 5ms liegt.

4. Verfahren nach einem der vorangehenden Ansprüche, **dadurch gekennzeichnet, dass** die die Unterbrechungszeit oder die Unterbrechungszeiten zwischen einem ersten Puls und einem späteren Puls so gewählt wird, dass in dieser Zeit das Reaktivgas mit der Targetoberfläche so weit reagieren kann, dass am Anfang des darauffolgenden Pulses die Targetoberfläche bezüglich Bedeckung im Wesentlichen gleichen Zwischenzustand ist wie am Anfang des ersten Pulses.

5. Verfahren nach Anspruch 4, **dadurch gekennzeichnet dass** der spätere Puls ein dem ersten Puls direkt folgender Puls, also kein weiterer Puls dazwischen liegt.

6. Verfahren nach einem der vorangehenden Ansprüche, **dadurch gekennzeichnet, dass** zumindest ein zweites Target verwendet wird und zum pulsweisen Spannungsbeaufschlagung der Leistungseintrag sequenziell vom ersten Target auf das zweite Target und gegebenenfalls sequenziell auf die weiteren Targets geschaltet wird, so dass während zumindest einer solchen Sequenz die Leistungsabgabe eines die Leistung bereitstellenden Generators der vorzugsweise ein DC-Generator ist, nicht unterbrochen wird.

7. Verfahren zur Regelung eines reaktiven Sputterverfahrens nach einem der vorangehenden Ansprüche, **dadurch gekennzeichnet, dass** beim Erreichen einer vorbestimmten mit einem zweiten Zwischenzustand der Targetoberfläche korrelierenden Spannung ein Spannungspuls beendet wird.

8. Verfahren zur Regelung eines reaktiven Sputterverfahrens nach einem der vorangehenden Ansprüche, **dadurch gekennzeichnet, dass** im Falle des Unterschreitens einer vorbestimmten Spannung am Pulsanfang die Unterbrechungszeit kürzer als die vorhergehenden Unterbrechungszeit gewählt wird und beim Überschreiten einer vorbestimmten Spannung am Pulsanfang die Unterbrechungszeit länger als die vorhergehenden Unterbrechungszeit gewählt wird.

9. Verfahren nach einem der vorangehenden Ansprüche, **dadurch gekennzeichnet, dass** der zweite Zwischenzustand im Wesentlichen der metallische Zustand oder nicht der metallische Zustand der Targetoberfläche ist.

## Claims

1. Method for reactive sputtering in which, by means of ion bombardment, material is ejected from the surface of a first target and passes into the gas phase, wherein negative voltage is applied pulse-wise to the target in such a way that an electric current having a current density of greater than 0.5A/cm² occurs at the target surface, so that the material passing into the gas phase is at least partially ionized, and in which a reactive gas flow is established and reactive gas reacts with the material of the target surface, wherein during a voltage pulse the target surface, at the location or locations at which the current flows, most of the time is covered at least partially with a compound composed of reactive gas and target material and consequently, the target surface to be sputtered is in a first intermediate state, **characterized in that** the power pulse generated by the voltage and the current can be maintained at least for most of the duration of the pulse, preferably for essentially the entire pulse duration, at an essentially constant power amplitude and the current density or the sputtering power density and the pulse duration are chosen such that the sputtered target surface at the end of the power pulse is in a second intermediate state in which the covering of the compound composed of reactive gas and target material is smaller at the end of the power pulse than at the beginning of the power pulse and this is recognizable in the voltage curve.

2. Method according to claim 1, **characterized in that** at the beginning of the power pulse a fist voltage level U1 and at the end of the power pulse a second voltage level U2 are measured, with U2 > U1.

3. Method according to one of the preceding claims, **characterized in that** the pulse duration is between 500µs and 100ms, preferably between 1ms and 10ms and even more preferably between 1ms and 5ms.

4. Method according to one of the preceding claims, **characterized in that** the interruption time or interruption times between a first pulse and a later pulse is/are chosen in such a way that in this time, the reactive gas reacts with the target surface to the point that at the beginning of the following pulse, the target surface with respect to the coverage has essentially the same intermediate state as at the beginning of the first pulse.

5. Method according to claim 4, **characterized in that** the later pulse can be a pulse directly following the first pulse, i.e. no further pulse occurs in-between.

6. Method according to one of the preceding claims, **characterized in that** at least a second target can be used and for the pulse-wise application of voltage, the power input can be switched sequentially from the first target to the second target and, if necessary, sequentially to the further targets, so that during at least one such sequence, the power output of a generator supplying the power, which is preferably a DC generator, is not interrupted.

7. Method for regulating a reactive sputtering process according to one of the preceding claims, **characterized in that** when a predetermined voltage correlating with a second intermediate state of the target surface is reached, a voltage pulse is terminated.

8. Method for regulating a reactive sputtering process according to one of the preceding claims, **characterized in that** in the event that a predetermined voltage at the beginning of a pulse is not reached, the interruption time is chosen to be shorter than the previous interruption time, and in the event that a predetermined voltage at the beginning of a pulse is exceeded, the interruption time is chosen to be longer than the previous interruption time.

9. Method according to one of the preceding claims, **characterized in that** the second intermediate state is essentially the metallic state or not the metallic state of the target surface.

## Revendications

1. Procédé de pulvérisation réactif où du matériau est éjecté de la surface d'une première cible au moyen de bombardement ionique et passe en phase gazeuse, une tension négative étant appliquée à la cible par impulsions de telle manière qu'un courant électrique ayant une densité de courant de plus de 0.5A/cm² apparaît à la surface de la cible de sorte que le matériau passant en phase gazeuse est ionisé du moins partiellement et où un flux de gaz réactif est établi et un gaz réactif réagit avec le matériau de la surface de la cible, pendant une impulsion de tension la surface de la cible étant couverte, à la position ou aux positions où le courant circule, la plupart du temps du moins partiellement d'un composé de gaz réactif et de matériau de cible et ainsi la surface à pulvériser est dans un premier état intermédiaire, **caractérisé en ce que** l'impulsion de puissance générée par la tension et le courant est maintenue du moins pendant la plupart du temps de l'impulsion, de préférence pendant essentiellement la durée totale de l'impulsion, à une amplitude de puissance essentiellement constante et la densité de courant ou la densité de puissance de pulvérisation ainsi reçue et la durée de l'impulsion sont choisies de telle manière que la surface de la cible pulvérisée est à la fin de l'impulsion de puissance dans un second état intermédiaire où le recouvrement du composé constitué de gaz réactif et de matériau de cible est inférieure à la fin de l'impulsion de puissance à celui au début de l'impulsion de puissance et cela est visible dans la courbe de tension.

2. Procédé selon la revendication 1 **caractérisé en ce qu'**au début de l'impulsion de puissance un premier niveau de tension U1 et à la fin de l'impulsion de puissance un second niveau de tension U2 sont mesurés, avec U2 > U1.

3. Procédé selon l'une des revendications précédentes **caractérisé en ce que** la durée d'impulsion est entre 500µs et 100ms, de préférence entre 1ms et 10ms et de façon particulièrement préférée entre 1ms et 5ms.

4. Procédé selon l'une des revendications précédentes **caractérisé en ce que** le temps d'interruption ou les temps d'interruption entre une première impulsion et une impulsion ultérieure est/sont choisis de telle manière que dans ce temps le gaz réactif peut réagir avec la surface de la cible à tel point qu'au début de l'impulsion suivante la surface de la cible relative au recouvrement est essentiellement dans le même état intermédiaire qu'au début de la première impulsion.

5. Procédé selon la revendication 4 **caractérisé en ce que** l'impulsion ultérieure est une impulsion suivant directement à la première impulsion, c'est-à-dire qu'il n'y a pas d'autre impulsion entre celles-ci.

6. Procédé selon l'une des revendications précédentes **caractérisé en ce que** du moins une seconde cible est utilisée et pour l'application de tension par impulsion la puissance consommée est commutée séquentiellement de la première cible à la deuxième cible et, si nécessaire, séquentiellement aux autre cibles de sorte que pendant du moins une telle séquence la puissance utile d'un générateur fournissant la puissance qui est de préférence un générateur DC, n'est pas interrompue.

7. Procédé de régulation d'un procédé de pulvérisation réactif selon l'une des revendications précédentes **caractérisé en ce que**, si une tension prédéfinie en corrélation avec un second état intermédiaire de la surface de la cible est atteinte, une impulsion de tension est terminée.

8. Procédé de régulation d'un procédé de pulvérisation réactif selon l'une des revendications précédentes **caractérisé en ce que**, si une tension prédéfinie n'est pas atteinte au début d'une impulsion, le temps d'interruption est choisi plus court que le temps d'interruption précédent et, si une tension prédéfinie est dépassée au début de l'impulsion, le temps d'interruption est choisi plus long que le temps d'interruption précédent.

9. Procédé selon l'une des revendications précédentes **caractérisé en ce que** le second état intermédiaire est essentiellement l'état métallique ou n'est pas l'état métallique de la surface de la cible.
